# EUROPÄISCHE PATENTSCHRIFT

(11) **EP 4 515 631 B1**
(45) Veröffentlichungstag und Bekanntmachung des Hinweises auf die Patenterteilung: **07.10.2026**
(21) Anmeldenummer: 23706338.3
(22) Anmeldetag: 20.02.2023
(51) Int. Cl.: H01R 12/58, H05K 5/06, H01R 13/52, H01R 13/652, H01R 4/70, H01R 12/71, H01R 13/533, H05K 5/00, H01R 13/405

(54) **MASSEKONTAKTMODUL FÜR EIN STEUERGERÄT SOWIE STEUERGERÄT UND MONTAGEVERFAHREN**
MASS-CONTACT MODULE FOR A CONTROL DEVICE, AND CONTROL DEVICE AND ASSEMBLY PROCESS
MODULE DE CONTACT DE MASSE POUR UN DISPOSITIF DE COMMANDE, ET DISPOSITIF DE COMMANDE ET PROCÉDÉ D'ASSEMBLAGE

(30) Priorität: 26.04.2022 DE 102022110010
(43) Veröffentlichungstag der Anmeldung: 05.03.2025
(73) Patentinhaber: ZF CV Systems Europe BV, 1170 Brüssel (BE)
(72) Erfinder: KORTLANG, Tobias, 30989 Gehrden (DE); QUERNHEIM, Lars, 30559 Hannover (DE)
(74) Vertreter: Copi, Joachim
(86) Internationale Anmeldenummer: PCT/EP2023/054163
(87) Internationale Veröffentlichungsnummer: WO 2023/208439

(56) Entgegenhaltungen:
- DE-A1- 102016 211 860
- JP-A- H04 370 672

## Beschreibung

Die Erfindung betrifft ein Massekontaktmodul für ein Steuergerät. Ein solches Massekontaktmodul umfasst einen sich in einer Längsrichtung erstreckenden Einpresskontakt mit einem Steckabschnitt zur Ausbildung einer elektrisch leitenden Einpressverbindung mit einer Leiterplatte und einen in Längsrichtung beabstandeten Endabschnitt, welcher zur Anlage an einer Anlagefläche ausgebildet ist.

Derartige Massekontaktmodule bzw. Massekontakte, auch als Erdungskontakte bezeichnet, sind allgemein bekannt. Sie werden in Steuergeräten verwendet, wie beispielsweise Steuergeräten für Kraftfahrzeuge, und dienen der lediglich elektrisch leitenden Verbindung einer Leiterplatte mit einem metallischen Gegenstand. Der Endabschnitt eines solchen Massekontaktmoduls weist aus diesem Grund auch keinen Stecker oder dergleichen auf, sondern ist einzig zur Anlage an einer Anlagefläche ausgebildet. Durch den Einsatz von Massekontaktmodulen soll die elektromagnetische Verträglichkeit von Steuergeräten und dergleichen erhöht werden.

DE102016211860A1 offenbart eine Steuergeräteeinheit und ein Verfahren zum Befestigen von geradlinigen Steckerpins einer Steuergeräteeinheit in einem Leiterplattenelement der Steuergeräteeinheit.

Gemäß der europäischen EMV-Richtlinie bezeichnet die elektromagnetische Verträglichkeit die Fähigkeit eines Apparates, einer Anlage oder eines Systems, in der elektromagnetischen Umwelt zufriedenstellend zu arbeiten, ohne dabei selbst elektromagnetische Störungen zu verursachen, die für alle in dieser Umwelt vorhandenen Apparate, Anlagen oder Systeme unannehmbar wären. Daraus werden die grundlegenden Schutzanforderungen abgeleitet, die jedes elektrische Gerät, das in Verkehr gebracht wird, einhalten muss. Die Schutzanforderungen legen fest, dass einerseits die Störaussendungen beispielsweise eines Steuergeräts so gering sein müssen, dass z. B. Rundfunkempfänger oder andere Betriebsmittel in der Störumgebung nicht unzulässig beeinflusst werden. Dabei handelt es sich um eine Begrenzung der Störquellen. Andererseits sollen die zu erwartenden auf das Steuergerät einwirkenden Störgrößen, wie Felder, Störströme oder Störspannungen dessen Funktion nicht beeinträchtigen.

Von besonderer Bedeutung ist die elektromagnetische Verträglichkeit in Fahrzeugen mit einem Elektroantrieb oder auch in zunehmend autonom betriebenen Fahrzeugen. Zum einen darf der sichere Betrieb des Steuergeräts, beispielsweise eines Motorsteuergeräts (ECU), nicht durch Felder, Störströme oder Störspannungen beeinträchtigt werden. Zum anderen darf ein solches Steuergerät auch die übrigen Komponenten eines Kraftfahrzeugs nicht beeinflussen, wie beispielsweise einen Elektromotor oder aber diverse Sensoren und Kommunikationsnetzwerke.

Zur Erhöhung der elektromagnetischen Verträglichkeit von Steuergeräten für Fahrzeuge, insbesondere Elektrofahrzeuge, sind Massekontaktmodule bekannt, welche als Federkontakt eine elektrisch leitende Verbindung zwischen der Leiterplatte und einem metallischen Gehäuseteil herstellen. Ferner sind Massekontakte für solche Steuergeräte bekannt, die als Einpresskontakt ausgebildet sind. Diese werden in eine korrespondierende Ausnehmung der Leiterplatte eingepresst, um eine kraftleitende sowie elektrisch leitende Verbindung mit der Leiterplatte einzugehen. Um Schäden an derartigen Massekontakten durch Vibrationen zu verhindern, weisen Steuergeräte ein Elektronikgehäuse auf, welches spezifische Ausnehmungen zur Führung der Einpresskontakte aufweist. Die Gestaltungsfreiheit von Elektronikgehäuse und damit der Anordnungsmöglichkeit der entsprechenden Massekontakte ist allerdings beschränkt.

Bei Einpressverbindungen von Leiterplatten und Massekontakten bzw. Massekontaktmodulen der eingangs beschriebenen Art muss sichergestellt werden, dass es zwischen der Leiterplatte und dem Einpresskontakt zu keiner Bewegung kommt. Durch eine Bewegung zwischen dem Einpresskontakt und der Leiterplatte, beispielsweise durch Erschütterungen im Betrieb, kann der Übergangswiderstand zwischen dem Einpresskontakt und der Leiterplatte zunehmen und es kommt zum Ausfall der Verbindung. Zur Vermeidung einer solchen Bewegung zwischen Einpresskontakt und Leiterplatte sind aus dem Stand der Technik Führungen im Elektronikgehäuse von Steuergeräten bekannt, welche eigens für den Massekontakt und korrespondierend zu dessen Form und Anordnung in das Elektronikgehäuse integriert werden. Dies schränkt die Designfreiheit von entsprechenden Steuergeräten stark ein und lässt insbesondere kein individuelles Nachrüsten von Massekontakten zu. Eine individuelle Nachrüstbarkeit von Massekontakten ist im Hinblick auf verschiedenste länderspezifische Gesetzgebungen bezüglich der Anforderungen an Steuergeräte für Kraftfahrzeuge wünschenswert.

Mit dem Ziel, die Kraftleitung zwischen dem Einpresskontakt und der Leiterplatte zu verbessern, ist ferner das Eingießen von Massekontakten mittels einer Vergussmasse bekannt. Bei derartigen Vergussmassen handelt es sich beispielsweise um PU-Vergussmassen. Diese gehen nur eine unzureichende Verbindung mit dem metallischen Massekontakt ein, sodass Feuchtigkeit an der Grenzfläche zwischen Vergussmasse und Massekontakt eintreten kann. Dies führt zur Korrosion des Massekontakts und schließlich zu einer mangelhaften elektrischen Leitung zwischen Leiterplatte und Massekontakt.

Es ist daher Aufgabe der vorliegenden Erfindung, zumindest einen der aus dem Stand der Technik bekannten Nachteile zu überwinden. Insbesondere ist Aufgabe der vorliegenden Erfindung, ein Massekontaktmodul für ein Steuergerät (ECU) anzugeben, welches eine hohe Designfreiheit des Steuergeräts sowie ein flexibles Nachrüsten zulässt, wobei eine ausreichende Sicherheit und Korrosionsbeständigkeit des Massekontaktmoduls gewährleistet sein muss.

Die Erfindung löst die eingangs genannte Aufgabe in einem ersten Aspekt durch ein Massekontaktmodul gemäß Anspruch 1. Die Erfindung schlägt bei einem Massekontaktmodul der eingangs genannten Art ein mit dem Einpresskontakt verbundenes Stützteil vor, welches dazu ausgestaltet ist, unter Ausbildung einer form- und/oder stoffschlüssigen Verbindung mit der Vergussmasse, eine kraftleitende Verbindung zwischen der Leiterplatte und dem Einpresskontakt zu bilden. Der Einpresskontakt wird somit sicher in dem Stützteil gehalten und geführt. Die Notwendigkeit einer eigens für den Einpresskontakt vorgesehenen Führung, beispielsweise im Elektronikgehäuse eines Steuergeräts, entfällt somit. Gleichzeitig wird durch die Ausbildung einer kraftleitenden Verbindung zwischen der Leiterplatte und dem Einpresskontakt zuverlässig eine Bewegung des Einpresskontaktes relativ zu besagter Leiterplatte verhindert. Ferner wird die Korrosion des Einpresskontakts durch die Verbindung mit dem Stützteil wirksam vermieden, da letztendlich nur das Stützteil eine mit der Umgebung in Kontakt stehende Grenzfläche zu der Vergussmasse aufweist, nicht aber der Einpresskontakt. Somit kann keine Feuchtigkeit aus der Umgebung an einer Grenzfläche zwischen dem Einpresskontakt und der Vergussmasse eintreten. Der Werkstoff des Stützteils kann dabei individuell auf den des Einpresskontakts abgestimmt werden, sodass ein Flüssigkeitseintritt zwischen dem Einpresskontakt und dem Stützteil vermieden werden kann. Ein derartiges Massekontaktmodul ist durch den modularen Aufbau mit einem Stützteil und einem Einpresskontakt einfach in bestehende Steuergeräte zu integrieren und hinsichtlich der Anordnung und Anzahl der Massekontaktmodule flexibel.

Eine kraftleitende Verbindung bezeichnet vorliegend eine Verbindung, welche das Leiten von Kräften zwischen der Leiterplatte und dem Einpresskontakt zulässt und im Falle von Vibrationen oder dergleichen eine Bewegung des Einpresskontakts relativ zu der Leiterplatte verhindert. Es soll ferner verstanden werden, dass die Ausbildung einer form- und/oder stoffschlüssigen Verbindung des Stützteils mit der Vergussmasse von der individuellen Materialpaarung abhängt. Abhängig von der Viskosität der Vergussmasse tritt diese auch in kleinste Hohlräume der Oberfläche des Stützteils ein und sorgt somit für eine formschlüssige Verbindung. Vorzugsweise umfasst das Stützteil einen hartelastischen Kunststoff. Wahlweise kann das Stützteil auch Hinterschnitte aufweisen, in welche die Vergussmasse eingebracht wird, sodass auch im makroskopischen Maßstab eine formschlüssige Verbindung ausgebildet wird. Zu einer stoffschlüssigen Verbindung kommt es ferner abhängig von der Materialpaarung durch kovalente Verbindungen, Ionenbindungen und Van-der-Waals-Kräfte, wobei die Verbindung chemisch induziert oder thermisch induziert erfolgen kann.

Es ist bevorzugt, dass das Stützteil einen Führungsabschnitt und einen gegenüber dem Führungsabschnitt quer zur Längsrichtung vorstehenden Verankerungsabschnitt aufweist. Der Führungsabschnitt ist zur Verbindung mit dem Einpresskontakt eingerichtet und der Verankerungsabschnitt ist zur formschlüssigen Verbindung mit der Vergussmasse eingerichtet. Durch den Führungsabschnitt können insbesondere auf den Einpresskontakt wirkende Biegelasten reduziert werden. Durch den quer zur Längsrichtung vorstehenden Verankerungsabschnitt wird ferner eine formschlüssige Verbindung des Stützteils mit der Vergussmasse im makroskopischen Maßstab gewährleistet. Dadurch sind zum Lösen des Massekontaktmoduls aus der Vergussmasse erhöhte Abziehkräfte notwendig. Der Führungsabschnitt erstreckt sich bevorzugt in Richtung des Endabschnitts, besonders bevorzugt vollständig entlang der Längserstreckung des Einpresskontakts bis hin zu dem Endabschnitt.

Vorzugsweise weist der Verankerungsabschnitt eine Ankerplatte auf und mindestens ein zwischen der Ankerplatte und dem Endabschnitt angeordnetes Krafteinleitungselement. Eine solche Ankerplatte ermöglicht eine verbesserte und großflächige Krafteinleitung in die Vergussmasse und erfordert insbesondere erhöhte Abzugskräfte zum Lösen des Stützteils aus der Vergussmasse. Die zwischen der Ankerplatte und dem Endabschnitt angeordneten Krafteinleitungselemente sollen dabei insbesondere die Abstützung des Einpresskontakts gegenüber Biegebelastungen und Kräften quer zur Längsrichtung erhöhen. Bevorzugt sind ein oder mehrere Krafteinleitungselemente vorgesehen, wobei die Krafteinleitungselemente als Stützstreben bzw. Flügel ausgebildet sind, welche in Richtung des Endabschnitts verjüngend ausgebildet sind.

Gemäß einer bevorzugten Ausführungsform ist das Stützteil mit einer Steckerbrücke integral ausgebildet. Grundelement einer Steckerbrücke ist zumeist ein aus hartelastischem Kunststoff ausgebildetes Formteil, in welchem ein oder mehrere Stecker bzw. Steckkontakte aufgenommen sind. Die einzelnen Stecker sind zur Ausbildung einer Signalverbindung eingerichtet und werden durch das Formteil elektrisch voneinander isoliert. Der Aufbau eines Steuergeräts mit einer solchen Steckerbrücke ist durch die Aufnahme einer Vielzahl von Steckern bzw. Steckkontakten in dem Formteil kompakter. Durch die integrale Ausbildung des Massekontaktmoduls an einer solchen Steckerbrücke wird die Montage weiter vereinfacht und der Aufbau eines entsprechenden Steuergeräts weiter optimiert. Die Anordnung der Steckerbrücke ist dahingehend limitiert, dass die Steckerbrücke mit den Steckkontakten zum Ausbilden einer Signalverbindung im Bereich entsprechender Öffnungen des Elektronikgehäuses angeordnet sein muss, sodass über Signalverbindungen Signale hin zu der Leiterplatte des Steuergeräts bzw. weg von dieser geleitet werden können.

Es ist weiterhin bevorzugt, dass das Stützteil einen Thermoplast umfasst, insbesondere Polybutylenterephthalat oder Polyamid. Thermoplaste, insbesondere Polybutylenterephthalat oder Polyamid, sind gut geeignet zur Verbindung mit herkömmlichen Vergussmassen, wie insbesondere PU-Vergussmassen. Insbesondere wird durch eine solche Materialkombination der Eintritt von Feuchtigkeit an der Grenzfläche des Stützteils und der Vergussmasse wirksam reduziert bzw. verhindert. Besonders bevorzugt ist der Thermoplast ein faserverstärkter Thermoplast mit einem Faseranteil von mindestens 10 %, vorzugsweise 20 %. Durch einen entsprechenden Faseranteil werden die mechanischen und insbesondere auch die thermischen Eigenschaften des Stützteils weiter verbessert. Somit wird die kraftleitende Verbindung des Einpresskontakts mit der Leiterplatte weiter verbessert und das Stützteil kann aufgrund der verbesserten mechanischen Eigenschaften des Werkstoffes kompakter ausgelegt werden, sodass Bauraum gespart wird. Bei den Fasern kann es sich bevorzugt um Glasfaser, Naturfasern oder keramische Fasern handeln. Bevorzugt sind die Verstärkungsfasern nichtleitend.

Weiter bevorzugt ist das Stützteil ein elektrischer Isolator. Somit erfolgt die elektrische Leitung des Massekontaktmoduls einzig über den Einpresskontakt, insbesondere gezielt über dessen Endabschnitt.

Gemäß einer bevorzugten Ausführungsform weist der Endabschnitt einen ersten Schenkel und einen zweiten Schenkel auf, die sich in Längsrichtung erstrecken und quer zur Längsrichtung relativ zueinander bewegbar bzw. zumindest elastisch verformbar sind, um jeweils mit einer Anlagefläche in Anlage zu kommen. Bevorzugt werden die Schenkel demnach zwischen zwei gegenüberliegenden Anlageflächen aufgenommen bzw. einer zylindrischen Anlagefläche, welche beispielsweise durch eine Bohrung bereitgestellt wird. Durch einen ersten Schenkel und einen zweiten Schenkel, welche jeweils mit einer Anlagefläche in Anlage kommen, wird die Sicherheit des Massekontaktmoduls dahingehend erhöht, dass auch bei Beschädigung eines der Schenkel bzw. Form- und Lageabweichungen desselbigen zumindest über den jeweils anderen Schenkel noch zuverlässig eine elektrische Leitung hin zu der Anlagefläche erfolgen kann. Bevorzugt weist ein Druckgussgehäuse eines Steuergeräts eine entsprechende Bohrung auf, deren Durchmesser dem äußeren Abstand der Kontaktflächen der Schenkel entspricht. Bevorzugt werden die Schenkel beim Einführen des Massekontaktmoduls zusammengepresst und federn nach dem Einführen in die entsprechende Aufnahmebohrung derart auseinander, dass jeder der Schenkel in einem Kontaktbereich jeweils mit einem Wandabschnitt der Bohrung im Druckgussgehäuse in Kontakt kommt. Die in der Bohrung aufgenommenen Schenkel federn bevorzugt durch eine Bewegung bzw. elastische Verformung quer zur Längsrichtung, in Richtung der Anlagefläche. Dieses nach außen gerichtete Federn der Schenkel führt zu einer zuverlässigen Verbindung der Schenkel und der Anlagefläche, welche bevorzugt durch die Wandung einer Bohrung ausgebildet ist.

Es ist bevorzugt, dass das Stützteil eine Einpressöffnung aufweist und der Einpresskontakt dazu eingerichtet ist, durch Einpressen in die Einpressöffnung in einer Einpressrichtung mit dem Stützteil verbunden zu sein. Durch Einpressen des metallischen Einpresskontakts in das Stützteil, welches insbesondere aus einem Isolator besteht, wird eine sichere und spielfreie Verbindung des Einpresskontakts und des Stützteils hergestellt. Diese Verbindung ist dabei insbesondere formschlüssig und verhindert eine Relativbewegung des Einpresskontakts relativ zu dem Stützteil quer zur Einpressrichtung. Es ist weiterhin bevorzugt, dass der Einpresskontakt eine Anzahl von Rückhalteelementen aufweist, die dazu eingerichtet sind, eine Bewegung des Einpresskontakts relativ zu dem Stützteil entgegen der Einpressrichtung zu verhindern. Die Rückhalteelemente sind beispielsweise Haken oder Zacken, welche bei einer Bewegung entgegen der Einpressrichtung in das Stützteil eingreifen. Weiterhin bevorzugt ist der Einpresskontakt dazu eingerichtet, durch Einpressen mittels Ultraschalleinbetten mit dem Stützteil verbunden zu werden. Beim Ultraschalleinbetten wird die Verbindungsqualität durch ein ultraschallbedingtes Anschmelzen des Stützteils weiter erhöht.

Gemäß einer alternativen bevorzugten Ausführungsform ist das Stützteil durch einen Spritzgussprozess hergestellt, in welchem der Einpresskontakt in das Spritzgusswerkzeug eingelegt wird und der Einpresskontakt zur Herstellung des Stützteils und Verbindung mit dem Stützteil umspritzt wird. Somit kann in nur einem Prozessschritt das Stützteil hergestellt werden und gleichzeitig eine Verbindung des Stützteils mit dem Einpresskontakt erfolgen. Die Fertigungszeiten für das Massekontaktmodul werden somit reduziert. Ferner wird eine zuverlässige Verbindung durch das Umspritzen des Einpresskontakts mit flüssiger Spritzgussmasse sichergestellt, welche das Eindringen von Feuchtigkeit verhindert. Spritzgussfähige Polymere weisen dabei bevorzugt eine geringe Viskosität auf, sodass auch kleinste Hohlräume ausgefüllt werden und der Korrosionsschutz sichergestellt ist.

Die Erfindung wurde vorstehend an einem ersten Aspekt in Bezug auf ein Massekontaktmodul beschrieben. Die Erfindung löst die eingangs genannte Aufgabe in einem zweiten Aspekt durch ein Steuergerät (ECU) für ein Kraftfahrzeug, welches ein Elektronikgehäuse, eine in dem Elektronikgehäuse angeordnete Leiterplatte, eine Vergussmasse, in welche die Leiterplatte eingebettet ist, eine metallische Anlagefläche und mindestens ein Massekontaktmodul gemäß dem ersten Aspekt der Erfindung umfasst. Die Erfindung schlägt gemäß dem zweiten Aspekt ferner vor, dass das Massekontaktmodul zum elektrisch leitenden Verbinden der Leiterplatte mit der metallischen Anlagefläche vorgesehen ist, wobei das Stützteil des Massekontaktmoduls unter Ausbildung einer form- und/oder stoffschlüssigen Verbindung mit der Vergussmasse eine kraftleitende Verbindung zwischen der Leiterplatte und dem Einpresskontakt bildet. Durch ein solches Massekontaktmodul gemäß dem ersten Aspekt der Erfindung macht sich das erfindungsgemäße Steuergerät (ECU) gemäß dem zweiten Aspekt der Erfindung die vorstehend beschriebenen Vorteile zu eigen. Vorteile und bevorzugte Ausführungsformen gemäß dem ersten Aspekt der Erfindung sind ebenso Vorteile und bevorzugte Ausführungsformen des Steuergeräts (ECU) gemäß dem zweiten Aspekt der Erfindung und umgekehrt.

Es ist bevorzugt, dass die Vergussmasse ein Duroplast umfasst, vorzugsweise Polyurethan. Das Vergießen mit duromeren Vergussmassen ist gut automatisierbar. Im Gegensatz zu Thermoplasten sind Duroplaste chemisch vernetzend und müssen somit nicht oberhalb der Schmelztemperatur gehalten werden, um fließfähig zu bleiben. Die Verarbeitbarkeit duromerer Vergussmassen ist somit vorteilhaft gegenüber thermoplastischen Vergussmassen. Weiterhin sind duromere Vergussmassen isolierend und somit gut für den Einsatz in Steuergeräten, insbesondere Motorsteuergeräten geeignet.

Weiter bevorzugt umfasst das Steuergerät eine Bohrung mit einer Wandung, welche die Anlagefläche ausbildet, und vorzugsweise ferner eine Einführfase, welche zum Zentrieren des Massekontaktmoduls eingerichtet ist. Durch die Zentrierung wird die Montage des Steuergeräts vereinfacht. Durch die Bereitstellung der Anlagefläche durch die Wandung der Bohrung, wird das Massekontaktmodul ferner gegen Kräfte quer zur Längsrichtung geschützt. Besonders bevorzugt ist die Bohrung in einem Druckgussgehäuse ausgebildet, welches zum Verschießen des Elektronikgehäuses eingerichtet ist.

Bevorzugt ist die Vergussmasse zur form- und stoffschlüssigen Verbindung mit dem Stützteil ausgebildet. Durch eine form- und eine stoffschlüssige Verbindung wird die Kraftübertragung zwischen dem Stützteil und der Vergussmasse weiter verbessert und das Eindringen von Feuchtigkeit in das Massekontaktmodul reduziert. Durch eine stoffschlüssige Verbindung zwischen Vergussmasse und Stützteil kann keine Feuchtigkeit in das Massekontaktmodul eintreten.

Die Erfindung löst die eingangs genannte Aufgabe in einem dritten Aspekt durch ein Montageverfahren zur Montage eines Steuergeräts, insbesondere eines Steuergeräts gemäß dem zweiten Aspekt der Erfindung, für ein Kraftfahrzeug. Das Montageverfahren umfasst dabei die Schritte:
- Verbinden einer Leiterplatte mit einem Elektronikgehäuse,
- Bereitstellen mindestens eines Massekontaktmoduls gemäß dem ersten Aspekt der Erfindung,
- Einpressen des Einpresskontakts des Massekontaktmoduls in eine korrespondierende Öffnung der Leiterplatte zur Ausbildung einer elektrisch leitenden Verbindung, und
- Gießen einer Vergussmasse in das Elektronikgehäuse zur Einbettung der Leiterplatte, wobei das Stützteil zur Ausbildung einer kraftleitenden Verbindung zwischen der Leiterplatte und dem Einpresskontakt von der Vergussmasse zumindest abschnittsweise eingebettet wird.

Durch die Bereitstellung eines Massekontaktmoduls gemäß dem ersten Aspekt der Erfindung und die Einbettung des Stützteils dieses Massekontaktmoduls in eine Vergussmasse macht sich das Montageverfahren die eingangs in Bezug auf den ersten Aspekt der Erfindung erläuterten Vorteile zu eigen. Vorteile und bevorzugte Ausführungsformen des ersten Aspekts der Erfindung sind ebenso bevorzugte Ausführungsformen und Vorteile gemäß dem dritten Aspekt der Erfindung und umgekehrt.

Ausführungsformen der Erfindung werden nun nachfolgend anhand der Zeichnung beschrieben. Diese soll die Ausführungsformen nicht notwendigerweise maßstäblich darstellen, vielmehr ist die Zeichnung, wo zur Erläuterung dienlich, in schematisierter und/oder leicht verzerrter Form ausgeführt. Im Hinblick auf Ergänzungen der aus der Zeichnung unmittelbar erkennbaren Lehren wird auf den einschlägigen Stand der Technik verwiesen. Dabei ist zu berücksichtigen, dass vielfältige Modifikationen und Änderungen betreffend die Form und das Detail einer Ausführungsform vorgenommen werden können, ohne von der allgemeinen Idee der Erfindung abzuweichen. Die in der Beschreibung, in der Zeichnung sowie in den Ansprüchen offenbarten Merkmale der Erfindung können sowohl einzeln als auch in beliebiger Kombination für die Weiterbildung der Erfindung wesentlich sein. Zudem fallen in den Rahmen der Erfindung alle Kombinationen aus zumindest zwei der in der Beschreibung, der Zeichnung und/oder den Ansprüchen offenbarten Merkmale. Die allgemeine Idee der Erfindung ist nicht beschränkt auf die exakte Form oder das Detail der im Folgenden gezeigten und beschriebenen bevorzugten Ausführungsformen oder beschränkt auf einen Gegenstand, der eingeschränkt wäre im Vergleich zu dem in den Ansprüchen beanspruchten Gegenstand. Bei angegebenen Bemessungsbereichen sollen auch innerhalb der genannten Grenzen liegende Werte als Grenzwerte offenbart und beliebig einsetzbar und beanspruchbar sein. Der Einfachheit halber sind nachfolgend für identische oder ähnliche Teile oder Teile mit identischer oder ähnlicher Funktion gleiche Bezugszeichen verwendet.

Weitere Vorteile, Merkmale und Einzelheiten der Erfindung ergeben sich aus der nachfolgenden Beschreibung der bevorzugten Ausführungsformen sowie anhand der Zeichnungen, diese zeigen in:
- Fig. 1: ein Steuergerät gemäß der Erfindung in einem vormontierten Zustand in einer perspektivischen Ansicht;
- Fig. 2: das Steuergerät gemäß Fig. 1 in einem montierten Zustand in einer perspektivischen Ansicht;
- Fig. 3: eine teilgeschnittene Seitenansicht des Steuergeräts gemäß Fig. 2;
- Fig. 4: ein Steuergerät gemäß einer zweiten Ausführungsform in einer perspektivischen Ansicht;
- Fig. 5a: ein Massekontaktmodul gemäß einer ersten Ausführungsform in einer geschnittenen Seitenansicht;
- Fig. 5b: das Massekontaktmodul gemäß Fig. 5a in einer Seitenansicht;
- Fig. 6a: ein Massekontaktmodul gemäß einer zweiten Ausführungsform in einer geschnittenen Seitenansicht;
- Fig. 6b: das Massekontaktmodul gemäß Fig. 6a in einer Seitenansicht;
- Fig. 7: ein Steuergerät mit einem Massekontaktmodul gemäß einer dritten bevorzugten Ausführungsform in einer geschnittenen Seitenansicht;
- Fig. 8a: ein Massekontaktmodul für das Steuergerät gemäß Fig. 7 in einer geschnittenen Seitenansicht; und
- Fig. 8b: das Massekontaktmodul gemäß Fig. 8a in einer Seitenansicht.

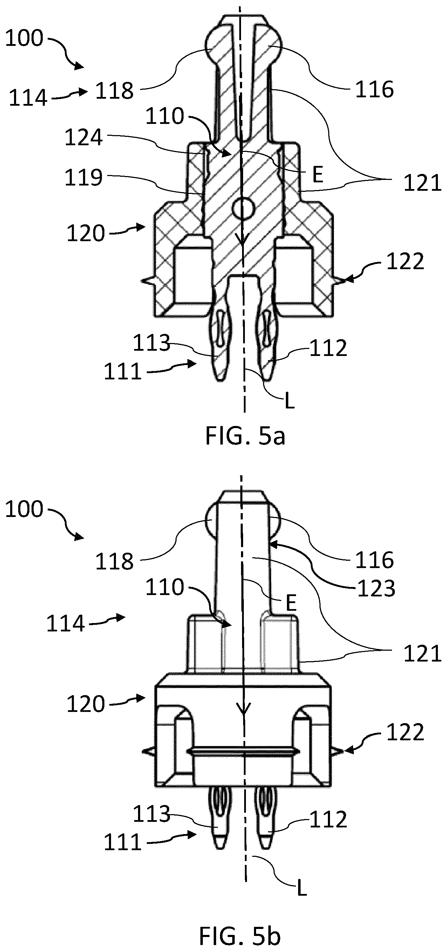

Ein Steuergerät 1000 für ein Kraftfahrzeug, auch als ECU bezeichnet, umfasst ein Elektronikgehäuse 200, wobei es sich insbesondere um ein Kunststoffgehäuse handelt. In dem Elektronikgehäuse 200 ist eine Leiterplatte 300 angeordnet, die insbesondere in das Elektronikgehäuse 200 eingepresst wird. Die Leiterplatte 300 weist eine erste Aufnahme 302 und eine zweite Aufnahme 304 auf, die dazu eingerichtet sind, einen ersten Pin 112 (vgl. Fig. 5a bis 6b) und einen zweiten Pin 113 (vgl. Fig. 5a bis 6b) aufzunehmen. In die Leiterplatte 300 ist ferner eine Steckerbrücke 400 eingepresst, welche ein Formteil 410 und insgesamt drei in dem Formteil 410 aufgenommene Stecker 421, 422, 423 aufweist.

Ferner weist das Steuergerät 1000 ein Massekontaktmodul 100 auf. Das Massekontaktmodul 100 ist dazu eingerichtet, in die erste Aufnahme 302 und die zweite Aufnahme 304 der Leiterplatte 300 eingebracht zu werden.

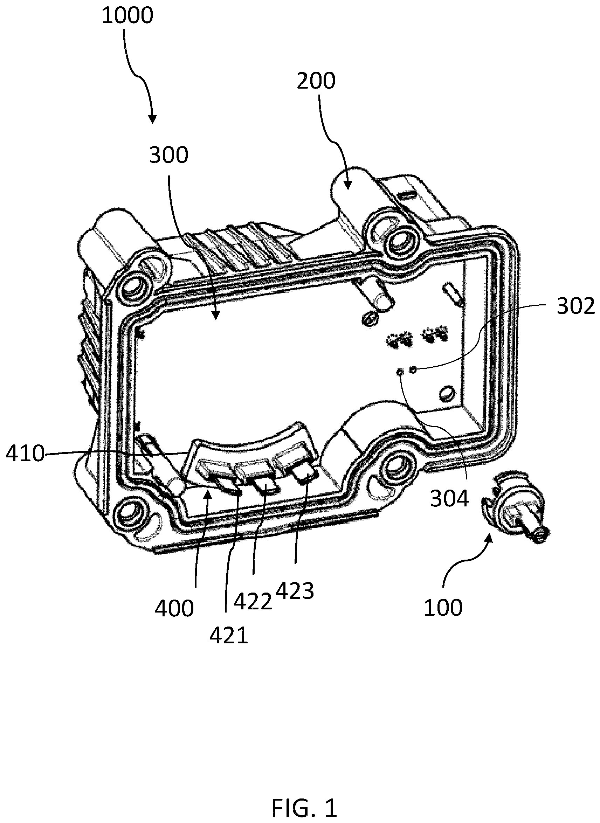

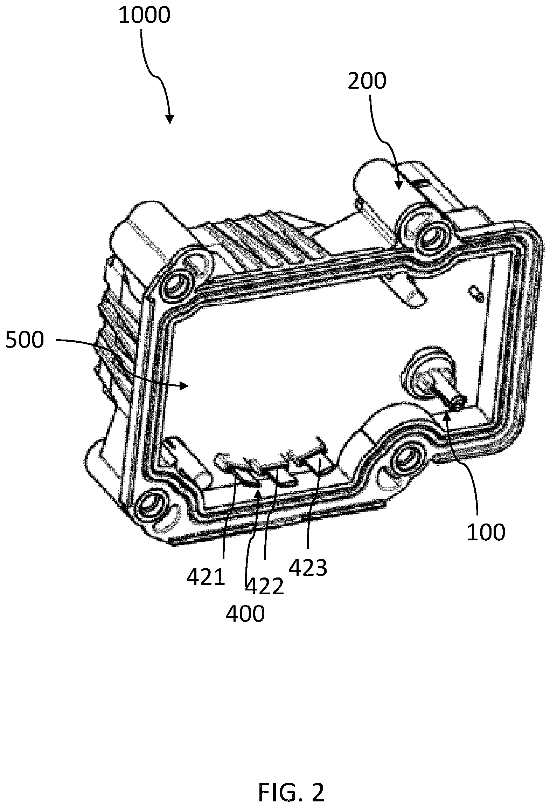

Wie insbesondere in Fig. 2 ersichtlich, ist die in Fig. 1 gezeigte Leiterplatte 300 dazu eingerichtet, vollständig in eine Vergussmasse 500 eingebettet zu werden.

Ferner ist auch die Steckerbrücke 400 in die Vergussmasse 500 eingebettet derart, dass nur noch ein oberer Abschnitt des Formteils 410 aus der Vergussmasse 500 herausragt. Die Steckkontakte bzw. Stecker 421, 422, 423 sind dazu eingerichtet, eine signalleitende Verbindung mit einem korrespondierenden Steckkontakt einzugehen.

Ferner ist das Massekontaktmodul 100 zumindest teilweise in die Vergussmasse 500 eingebettet. Das Massekontaktmodul 100 ist dabei lediglich zur Ausbildung eines elektrisch leitenden Massekontakts eingerichtet, welcher auch als Erdungskontakt bezeichnet wird.

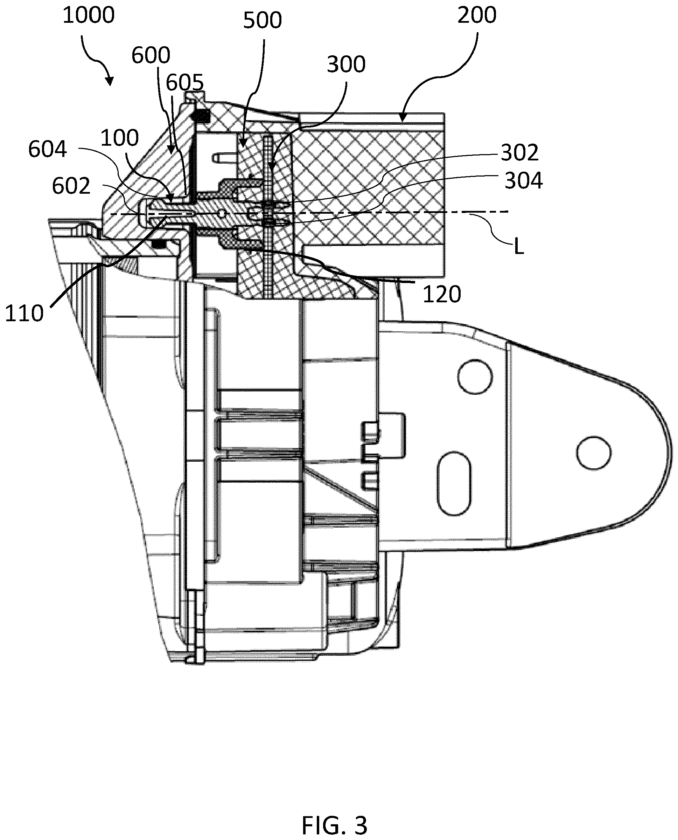

Wie insbesondere in der teilgeschnittenen Seitenansicht des Steuergeräts 1000 gemäß Fig. 3 gezeigt, erstreckt sich das Massekontaktmodul 100 in einer Längsrichtung L. Das Massekontaktmodul 100 umfasst dabei einen sich in Längsrichtung L erstreckenden Einpresskontakt 110 zur Ausbildung einer elektrisch leitenden Einpressverbindung mit der Leiterplatte 300 durch Einpressen in die erste Aufnahmeöffnung 302 und die zweite Aufnahmeöffnung 304. Ferner umfasst das Massekontaktmodul 100 ein mit dem Einpresskontakt 110 verbundenes Stützteil 120, welches dazu ausgestaltet ist, unter Ausbildung einer form- und/oder stoffschlüssigen Verbindung mit der Vergussmasse 500 eine kraftleitende Verbindung zwischen der Leiterplatte 300 und dem Einpresskontakt 110 zu bilden. Das Stützteil 120 ist dabei abschnittsweise in die Vergussmasse 500 eingebettet durch Eingießen der Vergussmasse 500 in das Elektronikgehäuse 200. Das Eingießen der Vergussmasse 500 in das Elektronikgehäuse 200 bedingt ferner das Einbetten der Leiterplatte 300.

Das Steuergerät 1000 umfasst ferner ein Druckgussgehäuse 600, welches einen Deckel des Elektronikgehäuses 200 ausbildet. Das Druckgussgehäuse 600 umfasst eine Bohrung 602 mit einer Anlagefläche 604. Die Anlagefläche 604 ist eine metallische Anlagefläche, welche mit dem Einpresskontakt 110 elektrisch leitend in Anlage ist. Somit wird die Anlagefläche 604 des Druckgussgehäuses 600 über das Massekontaktmodul 100 elektrisch leitend mit der Leiterplatte 300 verbunden. Durch die Bohrung 602, welche die Anlagefläche 604 bereitstellt, wird das Massekontaktmodul 100 gegenüber Radialkräften gesichert. Bevorzugt weist die Bohrung 602 eine Einführfase 605 zur Zentrierung des Massekontaktmoduls 100 auf.

Durch das Eingießen des Stützteils 120 in die Vergussmasse 500 und die dadurch ausgebildete form- und/oder stoffschlüssige Verbindung zwischen Stützteil 120 und Vergussmasse 500, ist der Einpresskontakt 110 sicher fixiert und eine Bewegung des Einpresskontakts 110 relativ zur Leiterplatte 300 wird vermieden. Der Einpresskontakt 110 ist dabei fest mit dem Stützteil 120 verbunden. Das Stützteil 120 ragt zumindest abschnittsweise aus der Vergussmasse 500 heraus, sodass Grenzflächen zwischen dem Einpresskontakt 110 und der Vergussmasse 500, welche das Eindringen von Feuchtigkeit ermöglichen würden, vollständig vermieden werden. Die einzige Grenzfläche zwischen dem Einpresskontakt 110 und der Vergussmasse 500 wird luftdicht von dem Stützteil 120 umschlossen, um das Eindringen von Feuchtigkeit zu verhindern.

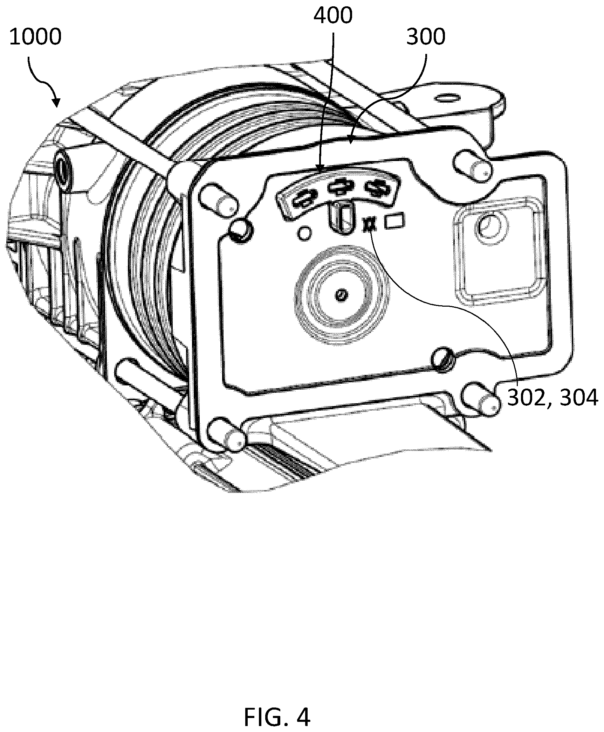

Die in Fig. 4 gezeigte Ausführungsform des Steuergeräts 1000 unterscheidet sich lediglich durch die Anordnung des in der Ansicht nicht gezeigten Massekontaktmoduls 100 bzw. der Anordnung von der ersten Aufnahme 302 und der zweiten Aufnahme 304 zur Ausbildung einer Einpressverbindung mit dem Einpresskontakt 110 (vgl. Fig. 1 bis 3). Es wird insoweit auf die Beschreibung des Steuergeräts 1000 gemäß den Fig. 1 bis 3 verwiesen. Gleiche und ähnliche Bauteile haben vorliegend identische Bezugszeichen. Das gezeigte Steuergerät 1000 weist dabei ebenfalls eine Leiterplatte 300 und eine mit dieser verbundene Steckerbrücke 400 auf.

Wie insbesondere die perspektivische Ansicht eines Steuergeräts 1000 gemäß Fig. 4 veranschaulicht, erlaubt das erfindungsgemäße Massekontaktmodul 100 an beliebiger Position mit einer Leiterplatte 300 verbunden zu werden. So können die entsprechenden Aufnahmen 302, 304 beispielsweise auch benachbart zu der Steckerbrücke 400 angeordnet sein. Der Einpresskontakt 110 (vgl. Fig. 3) wird dabei durch die Aufnahmen 302, 304 der Leiterplatte 300 hindurchgesteckt und würde im montierten Zustand aus der Leiterplatte 300 herausragen. In der gezeigten Ansicht ist das Elektronikgehäuse 200 ausgeblendet. Die Steckerbrücke 400 wird ebenfalls in die Leiterplatte 300 eingepresst und ragt aus dem in dieser Ansicht gezeigten Boden der Leiterplatte heraus. In dieser Form wird die Leiterplatte 300 dann in das entsprechende Elektronikgehäuse 200 (vgl. Fig. 3) des Steuergeräts 1000 eingepresst, bevor die Vergussmasse 500 eingegossen wird.

Die Montage des Steuergeräts 1000 gemäß der Figuren 1 bis 4 umfasst das Verbinden der Leiterplatte 300 mit dem Elektronikgehäuse 200, beispielsweise durch eine Schnappverbindung. Anschließend folgt die Bereitstellung des Massekontaktmoduls 100, welches durch Einpressen in die korrespondierenden Aufnahmen 302, 304 der Leiterplatte 300 eine elektrisch leitende Verbindung ausbildet. Zur Fixierung des Massekontaktmoduls 100 und Ausbildung einer kraftleitenden Verbindung zwischen der Leiterplatte 300 und dem Einpresskontakt 110, wird ferner die Vergussmasse 500 in das Elektronikgehäuse 200 zur Einbettung der Leiterplatte 300 und des Stützteils 120 in das Elektronikgehäuse 200 gegossen. Dabei geht das Stützteil 120 zur Ausbildung der kraftleitenden Verbindung zwischen der Leiterplatte 300 und dem Einpresskontakt 110 eine form- und/oder stoffschlüssige Verbindung mit der Vergussmasse 500 ein.

Die Fig. 5a und 5b zeigen das Massekontaktmodul 100 gemäß einer ersten Ausführungsform. Das Massekontaktmodul 100 weist einen sich in einer Längsrichtung L erstreckenden Einpresskontakt 110 mit einem Steckabschnitt 111 zur Ausbildung einer elektrisch leitenden Einpressverbindung mit der Leiterplatte 300 (vgl. Fig. 1 bis 4) und einen in Längsrichtung L beabstandeten Endabschnitt 114 auf. Der Endabschnitt 114 ist, wie in Fig. 3 gezeigt, zur Anlage an einer Anlagefläche 604 ausgebildet. Der Einpresskontakt 110 weist den Steckabschnitt 111 auf, bevorzugt mit einem ersten Pin 112 und einem zweiten Pin 113 zur Ausbildung einer Einpressverbindung mit der Leiterplatte 300.

Ferner umfasst das Massekontaktmodul 100 ein mit dem Einpresskontakt 110 verbundenes Stützteil 120. Das Stützteil 120 ist, wie in Fig. 3 gezeigt, dazu ausgestaltet, unter Ausbildung einer form- und/oder stoffschlüssigen Verbindung mit der Vergussmasse 500 eine kraftleitende Verbindung zwischen der Leiterplatte 300 und dem Einpresskontakt 110 zu bilden.

Das Stützteil 120 weist bevorzugt einen Führungsabschnitt 121 auf. Der Führungsabschnitt 121 erstreckt sich von einem zentralen Bereich des Einpresskontakts 110 hin bis zu dem Endabschnitt 114. Der Endabschnitt 114 weist einen ersten Schenkel 116 und einen zweiten Schenkel 118 auf, welche relativ zueinander in einer Richtung orthogonal zur Längsrichtung L bewegbar bzw. elastisch verformbar sind. Die Bewegung bzw. Verformung der Schenkel 116, 118 wird dabei durch den Führungsabschnitt 121 geführt.

Das Stützteil 120 weist ferner einen Verankerungsabschnitt 122 auf, welcher sich von dem Führungsabschnitt 121 hin zu dem Steckabschnitt 111 erstreckt. Der Verankerungsabschnitt 122 weist einen gegenüber dem Führungsabschnitt 121 größeren Durchmesser auf. Das Stützteil 120 ist dazu eingerichtet, mindestens im Bereich des Verankerungsabschnitts 122 in die Vergussmasse 500 eingebettet zu werden.

Der Verankerungsabschnitt 122 steht insbesondere abschnittsweise gegenüber dem Führungsabschnitt 121 quer zur Längsrichtung L derart vor, dass eine formschlüssige Verbindung zwischen dem Verankerungsabschnitt 122 und der Vergussmasse 500 ausgebildet wird (vgl. Fig. 3).

Im Bereich des Führungsabschnitts 121, insbesondere im Bereich des ersten und zweiten Schenkels 116, 118, ist eine Führungsöffnung 123 ausgebildet, in welcher die Schenkel 116, 118 bewegbar aufgenommen sind. Die Führungsöffnung 123 liegt in der Schnittebene der Fig. 5a und ist daher nur angedeutet.

Das Stützteil 120 weist ferner eine Einpressöffnung 124 auf, in welche der Einpresskontakt 110 eingepresst ist. Zur besseren Verankerung des Einpresskontakts 110 in der Einpressöffnung 124 weist der Einpresskontakt 110 eine Anzahl von Rückhalteelementen 119 auf, welche dazu eingerichtet sind, eine Bewegung des Einpresskontakts 110 in einer Einpressrichtung E zuzulassen und eine Bewegung entgegen der Einpressrichtung E zu verhindern.

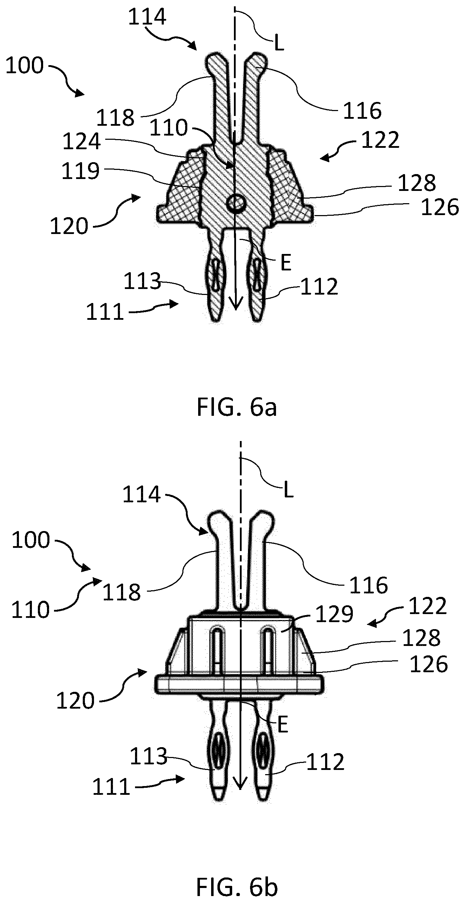

Die Fig. 6a und 6b zeigen eine zweite Ausführungsform des Massekontaktmoduls 100. Das Massekontaktmodul 100 umfasst, wie auch das in den Fig. 5a und 5b gezeigte Massekontaktmodul, einen sich in einer Längsrichtung L erstreckenden Einpresskontakt 110, dessen Ausbildung dem in den Fig. 5a und 5b gezeigten Einpresskontakt entspricht. Es wird insofern auf die vorstehende Beschreibung des Einpresskontakts 110 verwiesen.

Ferner umfasst das Massekontaktmodul 100 ein mit dem Einpresskontakt 110 verbundenes Stützteil 120, welches dazu ausgestaltet ist, unter Ausbildung einer formschlüssigen und vorzugsweise auch stoffschlüssigen Verbindung mit der Vergussmasse 500 (vgl. Fig. 1 bis 3), eine kraftleitende Verbindung zwischen der Leiterplatte 300 (vgl. Fig. 1 bis 3) und dem Einpresskontakt 110 zu bilden.

Das Stützteil 120 weist einen Verankerungsabschnitt 122 auf, welcher zwischen dem Endabschnitt 114 und dem Steckabschnitt 111 mit dem Einpresskontakt 110 verbunden ist. Wie insbesondere Fig. 6a zeigt, weist der Einpresskontakt 110 in dem mittigen Bereich eine Anzahl von Rückhalteelementen 119 auf, welche dazu eingerichtet sind, ein Lösen des Einpresskontakts 110 von dem Stützteil 120 zu verhindern.

Das Stützteil 120 weist eine Ankerplatte 126 auf, von welcher sich ein Halteabschnitt 129 mit konstantem Durchmesser in Richtung des Endabschnitts 114 erstreckt. Der Halteabschnitt 129 weist eine Anzahl von Krafteinleitungselementen 128 auf. Die Krafteinleitungselementen 128 erstrecken sich von der Ankerplatte 126 entlang des Halteabschnitts 129 in Richtung des Endabschnitts 114. In Längsrichtung L gesehen, sind die Krafteinleitungselemente 128 somit zwischen der Ankerplatte 126 und dem Endabschnitt 114 angeordnet. Die Krafteinleitungselemente 128 sind dazu eingerichtet, Kräfte aus dem Halteabschnitt 129, insbesondere dem Endabschnitt 114 des Einpresskontakts 110, in die Ankerplatte 126 zu leiten. Die Ankerplatte 126 ist dazu eingerichtet, zur kraftschlüssigen Verbindung des Einpresskontakts 110 mit einer Leiterplatte 300 vollständig in eine Vergussmasse 500 eingegossen zu werden (vgl. Fig. 1 bis 3). Durch den verglichen mit dem Halteabschnitt 129 vergrößerten Querschnitt der Ankerplatte126 in einer Ebene orthogonal zur Längsrichtung L wird die Krafteinleitung verbessert.

Die Krafteinleitungselemente 128 sind schräg zur Längsrichtung L ausgebildet, wobei sich die Außenkante der Krafteinleitungselemente 128 in Richtung des Endabschnitts 114 an den Halteabschnitt 129 annähert.

Ein entsprechendes Stützteil 120 ist bevorzugt aus einem Thermoplast, insbesondere Polybutylenterephthalat oder Polyamid, also einem hartelastischen Kunststoff hergestellt. Diese lassen sich bevorzugt in einem Spritzgussprozess herstellen, wobei die Ausbildung der Krafteinleitungselemente 128 und der Ankerplatte 126 eine Herstellung im Spritzgussprozess in vorteilhafter Weise zulassen.

Besonders bevorzugt umfasst das Stützteil einen faserverstärkten Thermoplast mit einem Faseranteil von mindestens 10 %, vorzugsweise 20 %. Bei den Verstärkungsfasern handelt es sich insbesondere um Glasfasern. Auch in dem in den Fig. 6a und 6b gezeigten Ausführungsbeispiel wird der Einpresskontakt 110 in einer Einpressrichtung E in die Einpressöffnung 124 des Stützteils 120 eingepresst. Die Rückhalteelemente 119 verhindern eine Bewegung des Einpresskontakts entgegen der Einpressrichtung E durch Eingreifen in die korrespondierende Wandung des Stützteils 120.

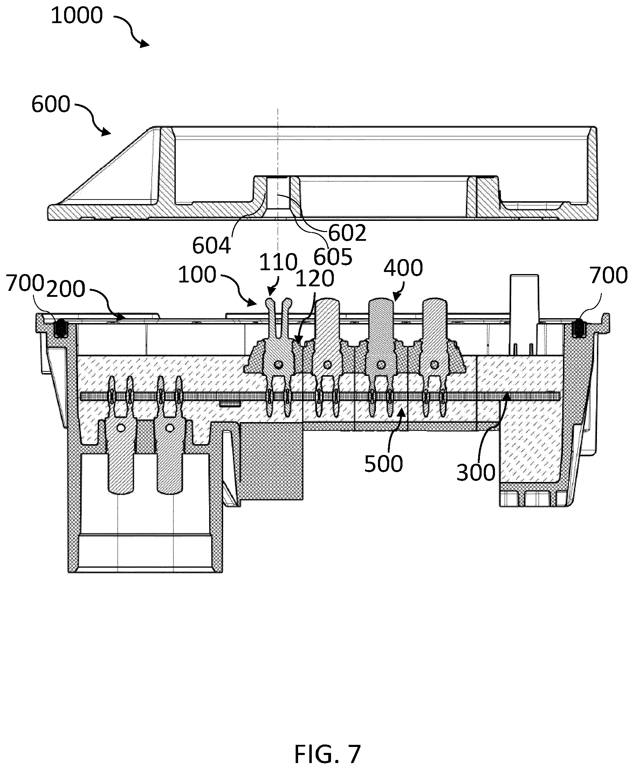

Fig. 7 zeigt eine weitere Ausführungsform eines Steuergeräts 1000. Das Steuergerät 1000 umfasst ein Elektronikgehäuse 200, in welchem eine Leiterplatte 300 aufgenommen ist. Das Elektronikgehäuse 200 ist mittels eines Druckgussgehäuses 600 verschließbar. Das Steuergerät 1000 weist zum elektrisch leitenden Verbinden der Leiterplatte 300 mit einer in einer Bohrung 602 ausgebildeten Anlagefläche 604 ein Massekontaktmodul 100 auf. Das Massekontaktmodul 100 stellt somit einen Erdungskontakt für die Leiterplatte 300 bereit. Das Massekontaktmodul 100 ist integral an einer Steckerbrücke 400 ausgebildet. Die Leiterplatte 300 ist in einer Vergussmasse 500 eingebettet. Ferner ist auch die Steckerbrücke 400 einschließlich des Massekontaktmoduls 100 zumindest abschnittsweise in die Vergussmasse 500 eingebettet. Das Massekontaktmodul 100 ist im Wesentlichen identisch zu dem in den Fig. 6a und 6b gezeigten Massekontaktmodul ausgebildet. Es weist in bekannter Weise einen Einpresskontakt 110 und ein Stützteil 120 auf.

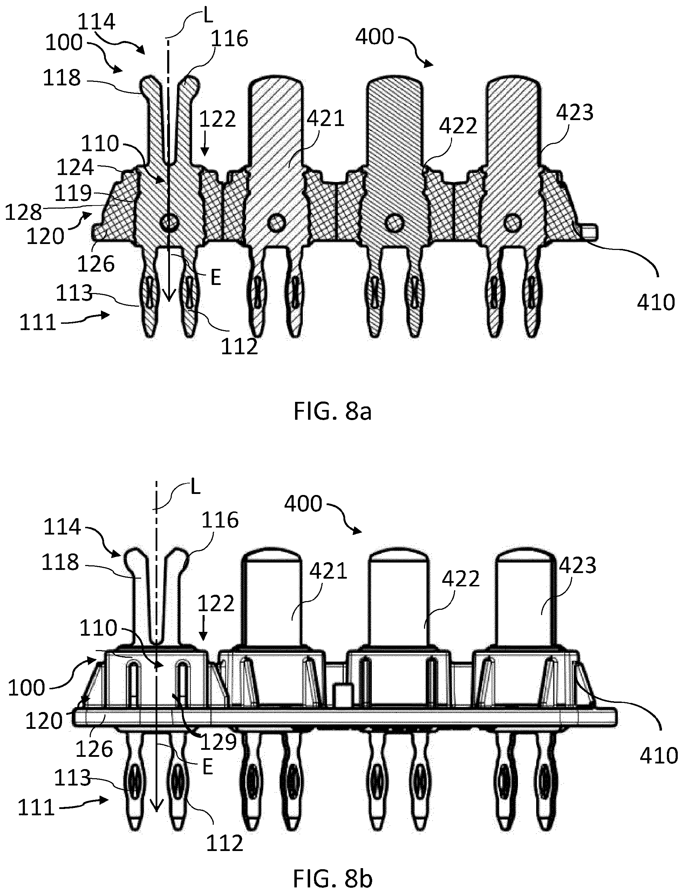

Wie in den Fig. 8a und 8b im Detail gezeigt, weist die Steckerbrücke 400 einen ersten Stecker 421, einen zweiten Stecker 422 und einen dritten Stecker 423 auf, welche in einem Formteil 410 aufgenommen sind. Das Stützteil 120 ist mit dem Formteil 410 verbunden. Die Verbindung kann dabei sowohl stoffschlüssig erfolgen, beispielsweise durch Herstellung des Stützteils 120 gemeinsam mit dem Formteil 410 in einem Spritzgussprozess, oder aber durch Fügeverfahren, wie beispielsweise Kunststoffschweißen oder Kleben.

Das Druckgussgehäuse 600 weist eine Einführfase 605 an der Mündung der Bohrung 602 auf. Die Einführfase 605 ist dazu eingerichtet, das Massekontaktmodul 100 zu zentrieren. Die Bohrung 602 ist korrespondierend zur Anordnung des Massekontaktmoduls 100 in dem Druckgussgehäuse 600 ausgebildet. Durch die Einführfase 605 weist die Bohrung 602 öffnungsseitig einen vergrößerten Durchmesser auf. Die Schenkel 116, 118 des Einpresskontakts 110 und insbesondere des Steckabschnitts 111 kommen mit der Einführfase 605 in Kontakt und werden von dieser gegeneinandergedrückt, beim Aufsetzen des Druckgussgehäuses 600 auf das Elektronikgehäuse 200. In einem Zustand, in welchem das Druckgussgehäuse 600 das Elektronikgehäuse 200 vollständig verschließt, sind die Schenkel 116, 118 vollständig in der Bohrung 602 aufgenommen und mit der Anlagefläche 604 elektrisch leitend in Kontakt.

Im Bereich der Stecker 421, 422, 423 weist das Druckgussgehäuse 600 eine Ausnehmung auf, welche die Verbindung der Stecker 421, 422, 423 mit weiteren Steckkontakten zur Signalübertragung zulässt.

Das Steuergerät 1000 weist ferner eine Dichtung 700 auf, welche sich bevorzugt durchgängig entlang des Elektronikgehäuses 200 in einer Aufnahmenut 201 erstreckt, um im geschlossenen Zustand des Steuergeräts 1000 das Gehäuseinnere abzudichten.

Wie ferner die Fig. 8a und 8b im Detail zeigen, weist das Massekontaktmodul 100, analog zu der in den Fig. 6a und 6b gezeigten Ausführungsform, einen sich in einer Längsrichtung L erstreckenden Einpresskontakt 110 auf. Ferner umfasst das Massekontaktmodul 100 ein mit dem Einpresskontakt 110 verbundenes Stützteil 120, welches dazu ausgestaltet ist, unter Ausbildung einer formschlüssigen und vorzugsweise auch stoffschlüssigen Verbindung mit der Vergussmasse (vgl. Fig. 1 bis 3), eine kraftleitende Verbindung zwischen der Leiterplatte 300 (vgl. Fig. 1 bis 3) und dem Einpresskontakt 110 zu bilden.

Das Stützteil 120 weist einen Verankerungsabschnitt 122 auf, welcher zwischen dem Endabschnitt 114 und dem Steckabschnitt 111 mit dem Einpresskontakt 110 verbunden ist. Wie insbesondere Fig. 8a zeigt, weist der Einpresskontakt 110 in dem mittigen Bereich eine Anzahl von Rückhalteelementen 119 auf, welche dazu eingerichtet sind, ein Lösen des Einpresskontakts 110 von dem Stützteil 120 zu verhindern.

Das Stützteil 120 weist eine Ankerplatte 126 auf, von welcher sich ein Halteabschnitt 129 mit konstantem Durchmesser in Richtung des Endabschnitts 114 erstreckt. Der Halteabschnitt 129 weist eine Anzahl von Krafteinleitungselementen 128 auf, welche sich von der Ankerplatte 126 entlang des Halteabschnitts 129 in Richtung des Endabschnitts 114 erstrecken. In Längsrichtung L gesehen, sind die Krafteinleitungselemente 128 somit zwischen der Ankerplatte 126 und dem Endabschnitt 114 angeordnet. Die Krafteinleitungselemente 128 sind dazu eingerichtet, Kräfte aus dem Halteabschnitt 129 und insbesondere dem Endabschnitt 114 des Einpresskontakts 110 in die Ankerplatte 126 zu leiten. Die Ankerplatte 126 ist dazu eingerichtet, zur kraftschlüssigen Verbindung des Einpresskontakts 110 mit einer Leiterplatte 300 vollständig in eine Vergussmasse 500 eingegossen zu werden.

Die Krafteinleitungselemente 128 sind schräg zur Längsrichtung L ausgebildet, wobei sich die Außenkante der Krafteinleitungselemente 128 in Richtung des Endabschnitts 114 an den Halteabschnitt 129 annähert. Ein solches Stützteil 120 ist bevorzugt aus einem Thermoplast, insbesondere Polybutylenterephthalat oder Polyamid, also einem hartelastischen Kunststoff hergestellt. Diese lassen sich bevorzugt in einem Spritzgussprozess herstellen. Besonders bevorzugt umfasst das Stützteil einen faserverstärkten Thermoplast mit einem Faseranteil von mindestens 10 %, vorzugsweise 20 %. Bei den Verstärkungsfasern handelt es sich insbesondere um Glasfasern. Auch in dem in den Fig. 8a und 8b gezeigten Ausführungsbeispiel wird der Einpresskontakt 110 in einer Einpressrichtung E in die Einpressöffnung 124 des Stützteils 120 eingepresst. Die Rückhalteelemente 119 verhindern eine Bewegung des Einpresskontakts entgegen der Einpressrichtung E durch Eingreifen in die korrespondierende Wandung des Stützteils 120.

### Bezugszeichenliste (Teil der Beschreibung)

- 1000: Steuergerät
- 100: Massekontaktmodul
- 110: Einpresskontakt
- 111: Steckabschnitt
- 112: erster Pin
- 113: zweiter Pin
- 114: Endabschnitt
- 116: erster Schenkel
- 118: zweiter Schenkel
- 119: Rückhalteelemente
- 120: Stützteil
- 121: Führungsabschnitt
- 122: Verankerungsabschnitt
- 123: Führungsöffnung
- 124: Einpressöffnung
- 126: Ankerplatte
- 128: Krafteinleitungselement
- 129: Halteabschnitt
- 200: Elektronikgehäuse
- 300: Leiterplatte
- 302: erste Aufnahme
- 304: zweite Aufnahme
- 400: Steckerbrücke
- 410: Formteil
- 421: erster Stecker
- 422: zweiter Stecker
- 423: dritter Stecker
- 500: Vergussmasse
- 600: Druckgussgehäuse
- 602: Öffnung
- 604: Anlagefläche
- 605: Einführfase
- L: Längsrichtung
- E: Einpressrichtung

## Patentansprüche

1. Massekontaktmodul (100) für ein Steuergerät (1000) (ECU), umfassend:
- einen sich in einer Längsrichtung (L) erstreckenden Einpresskontakt (110) mit einem Steckabschnitt (111) zur Ausbildung einer elektrisch leitenden Einpressverbindung mit einer Leiterplatte (300), und einem in Längsrichtung (L) beabstandeten Endabschnitt (114), welcher zur Anlage an einer Anlagefläche (604) ausgebildet ist,
**gekennzeichnet durch**
- ein mit dem Einpresskontakt (110) verbundenes Stützteil (120), welches dazu ausgestaltet ist, unter Ausbildung einer form- und/oder stoffschlüssigen Verbindung mit einer Vergussmasse (500), eine kraftleitende Verbindung zwischen der Leiterplatte (300) und dem Einpresskontakt (110) zu bilden, wobei
das Stützteil (120) einen Führungsabschnitt (121) und einen gegenüber dem Führungsabschnitt (121) quer zur Längsrichtung (L) vorstehenden Verankerungsabschnitt (122) aufweist,
wobei der Führungsabschnitt (121) zur Verbindung mit dem Einpresskontakt (110) eingerichtet ist und der Verankerungsabschnitt (122) zur formschlüssigen Verbindung mit der Vergussmasse (500) eingerichtet ist.

2. Massekontaktmodul (100) nach Anspruch 1,
**dadurch gekennzeichnet, dass** der Verankerungsabschnitt (122) eine Ankerplatte (126) aufweist und mindestens ein zwischen der Ankerplatte (126) und dem Endabschnitt (114) angeordnetes Krafteinleitungselement (128) aufweist.

3. Massekontaktmodul (100) nach einem der vorstehenden Ansprüche, **dadurch gekennzeichnet, dass** das Stützteil (120) mit einer Steckerbrücke (400) integral ausgebildet ist.

4. Massekontaktmodul (100) nach einem der vorstehenden Ansprüche, **dadurch gekennzeichnet, dass** das Stützteil (120) einen Thermoplast umfasst, insbesondere Polybutylenterephthalat oder Polyamid.

5. Massekontaktmodul (100) nach Anspruch 4,
**dadurch gekennzeichnet, dass** der Thermoplast ein faserverstärkter Thermoplast ist mit einem Faseranteil von mindestens 10%, vorzugsweise von 20 %.

6. Massekontaktmodul (100) nach einem der vorstehenden Ansprüche, **dadurch gekennzeichnet, dass** das Stützteil (120) ein elektrischer Isolator ist.

7. Massekontaktmodul (100) nach einem der vorstehenden Ansprüche, **dadurch gekennzeichnet, dass** der Endabschnitt (114) einen ersten Schenkel (116) und einen zweiten Schenkel (118) aufweist, die sich in Längsrichtung (L) erstrecken und quer zur Längsrichtung (L) relativ zueinander bewegbar bzw. elastisch verformbar sind, um jeweils mit einer Anlagefläche (604) in Anlage zu kommen.

8. Massekontaktmodul (100) nach Anspruch 7, **dadurch gekennzeichnet, dass** der Führungsabschnitt (121) eine sich in Längsrichtung (L) erstreckende Führungsöffnung (123) aufweist, in welcher der erste Schenkel (116) und der zweite Schenkel (118) quer zur Längsrichtung (L) bewegbar aufgenommen sind.

9. Massekontaktmodul (100) nach einem der vorstehenden Ansprüche, **dadurch gekennzeichnet, dass** das Stützteil (120) eine Einpressöffnung (124) aufweist und der Einpresskontakt (110) dazu ausgestaltet ist, durch Einpressen in die Einpressöffnung (124) in einer Einpressrichtung (E) mit dem Stützteil (120) verbunden zu sein.

10. Massekontaktmodul (100) nach Anspruch 9, **dadurch gekennzeichnet, dass** der Einpresskontakt (110) eine Anzahl von Rückhalteelementen (119) aufweist, die dazu eingerichtet sind, eine Bewegung des Einpresskontakts (110) relativ zu dem Stützteil (120) entgegen der Einpressrichtung (E) zu verhindern.

11. Massekontaktmodul (100) nach einem der vorstehenden Ansprüche, **dadurch gekennzeichnet, dass** der Einpresskontakt (110) dazu eingerichtet ist, durch Einpressen mittels Ultraschalleinbetten mit dem Stützteil (120) verbunden zu sein.

12. Massekontaktmodul (100) nach einem der Ansprüche 1 bis 8, **dadurch gekennzeichnet, dass** das Stützteil (120) durch einen Spritzgussprozess hergestellt ist, in welchem der Einpresskontakt (110) in das Spritzgusswerkzeug eingelegt wird und der Einpresskontakt (110) zur Herstellung des Stützteils (120) und Verbindung mit dem Stützteil (120) umspritzt wird.

13. Steuergerät (1000) (ECU) für ein Kraftfahrzeug, umfassend:
- ein Elektronikgehäuse (200),
- eine in dem Elektronikgehäuse (200) angeordnete Leiterplatte (300),
- eine Vergussmasse (500), in welche die Leiterplatte (300) eingebettet ist,
- eine metallische Anlagefläche (604), und
- mindestens ein Massekontaktmodul (100) zum elektrisch leitenden Verbinden der Leiterplatte (300) mit der metallischen Anlagefläche (604), **dadurch gekennzeichnet, dass** das Massekontaktmodul (100) umfasst:
- einen sich in einer Längsrichtung (L) erstreckenden Einpresskontakt (110) mit einem Steckabschnitt (111) zur Ausbildung einer elektrisch leitenden Einpressverbindung mit der Leiterplatte (300), und einem in Längsrichtung (L) beabstandeten Endabschnitt (114), welcher zur Anlage an der Anlagefläche (604) ausgebildet ist, und
- ein mit dem Einpresskontakt (110) verbundenes Stützteil (120), welches unter Ausbildung einer form- und/oder stoffschlüssigen Verbindung mit der Vergussmasse (500), eine kraftleitende Verbindung zwischen der Leiterplatte (300) und dem Einpresskontakt (110) bildet.

14. Steuergerät (1000) nach Anspruch 13, **dadurch gekennzeichnet, dass** das Massekontaktmodul (100) nach einem der Ansprüche 1 bis 12 ausgebildet ist.

15. Steuergerät (1000) nach Anspruch 13,
**gekennzeichnet durch** eine Bohrung (602) mit einer Wandung, welche die Anlagefläche (604) ausbildet, und einer Einführfase (605), welche zum Zentrieren des Massekontaktmoduls (100) eingerichtet ist.

16. Steuergerät (1000) nach Anspruch 13 oder 15,
**dadurch gekennzeichnet, dass** die Vergussmasse (500) ein Duroplast umfasst, vorzugsweise Polyurethan.

17. Steuergerät (1000) nach einem der Ansprüche 13, 15 oder 16, **dadurch gekennzeichnet, dass** die Vergussmasse (500) zur form- und stoffschlüssigen Verbindung mit dem Stützteil (120) ausgebildet ist.

18. Montageverfahren zur Montage eines Steuergeräts (1000) für ein Kraftfahrzeug, wobei das Montageverfahren die Schritte umfasst:
- Verbinden einer Leiterplatte (300) mit einem Elektronikgehäuse (200),
- Bereitstellen mindestens eines Massekontaktmoduls (100) nach einem der Ansprüche 1 bis 12
- Einpressen des Einpresskontakts (110) des Massekontaktmoduls (100) in eine korrespondierende Öffnung der Leiterplatte (300) zur Ausbildung einer elektrisch leitenden Verbindung, und
- Gießen einer Vergussmasse (500) in das Elektronikgehäuse (200) zur Einbettung der Leiterplatte (300), wobei das Stützteil (120) zur Ausbildung einer kraftleitenden Verbindung zwischen der Leiterplatte (300) und dem Einpresskontakt (110) von der Vergussmasse (500) zumindest abschnittsweise eingebettet wird.

## Claims

1. Ground contact module (100) for a control unit (1000) (ECU), comprising:
- a press-fit contact (110) extending in a longitudinal direction (L) with a plug-in section (111) for forming an electrically conductive press-fit connection to a circuit board (300), and an end section (114) spaced apart in the longitudinal direction (L), which is designed to be placed against a contact surface (604),
**characterized by**
- a support part (120) connected to the press-fit contact (110), which part is designed to form a force-conducting connection between the circuit board (300) and the press-fit contact (110) by forming a form-fit and/or material-fit connection to a potting compound (500), wherein
the support part (120) has a guide section (121) and an anchoring section (122) projecting transversely to the longitudinal direction (L) relative to the guide section (121),
wherein the guide section (121) is configured for connection to the press-fit contact (110) and the anchoring section (122) is configured for form-fit connection to the potting compound (500).

2. Ground contact module (100) according to claim 1,
**characterized in that** the anchoring section (122) has an anchor plate (126) and has at least one force introduction element (128) arranged between the anchor plate (126) and the end section (114).

3. Ground contact module (100) according to either of the preceding claims, **characterized in that** the support part (120) is integrally formed with a connector bridge (400).

4. Ground contact module (100) according to any of the preceding claims, **characterized in that** the support part (120) comprises a thermoplastic, in particular polybutylene terephthalate or polyamide.

5. Ground contact module (100) according to claim 4, **characterized in that** the thermoplastic is a fiber-reinforced thermoplastic with a fiber content of at least 10%, preferably 20%.

6. Ground contact module (100) according to any of the preceding claims, **characterized in that** the support part (120) is an electrical insulator.

7. Ground contact module (100) according to any of the preceding claims, **characterized in that** the end section (114) has a first leg (116) and a second leg (118) which extend in the longitudinal direction (L) and are movable or elastically deformable relative to each other transversely to the longitudinal direction (L) in order to come into contact with a contact surface (604).

8. Ground contact module (100) according to claim 7,
**characterized in that** the guide section (121) has a guide opening (123) extending in the longitudinal direction (L), in which opening the first leg (116) and the second leg (118) are movably received transversely to the longitudinal direction (L).

9. Ground contact module (100) according to any of the preceding claims, **characterized in that** the support part (120) has a press-fit opening (124) and the press-fit contact (110) is designed to be connected to the support part (120) by being pressed into the press-fit opening (124) in a press-fit direction (E).

10. Ground contact module (100) according to claim 9,
**characterized in that** the press-fit contact (110) has a number of retaining elements (119) which are configured to prevent movement of the press-fit contact (110) relative to the support part (120) counter to the press-fit direction (E).

11. Ground contact module (100) according to any of the preceding claims, **characterized in that** the press-fit contact (110) is configured to be connected to the support part (120) by being pressed in using ultrasonic embedding.

12. Ground contact module (100) according to any of claims 1 to 8, **characterized in that** the support part (120) is produced by an injection molding process in which the press-fit contact (110) is inserted into the injection molding tool and the press-fit contact (110) is overmolded to produce the support part (120) and connect it to the support part (120).

13. Motor vehicle control unit (1000) (ECU), comprising:
- an electronics housing (200),
- a circuit board (300) arranged in the electronics housing (200),
- a potting compound (500) in which the circuit board (300) is embedded,
- a metal contact surface (604), and
- at least one ground contact module (100) for electrically conductively connecting the circuit board (300) to the metal contact surface (604),
**characterized in that** the ground contact module (100) comprises:
- a press-fit contact (110) extending in a longitudinal direction (L) with a plug-in section (111) for forming an electrically conductive press-fit connection to the circuit board (300), and an end section (114) spaced apart in the longitudinal direction (L), which is designed to be placed against the contact surface (604), and
- a support part (120) connected to the press-fit contact (110), which part forms a force-conducting connection between the circuit board (300) and the press-fit contact (110) by forming a form-fit and/or material-fit connection to the potting compound (500).

14. Control unit (1000) according to claim 13, **characterized in that** the ground contact module (100) is designed according to any of claims 1 to 12.

15. Control unit (1000) according to claim 13, **characterized by** a bore (602) with a wall which forms the contact surface (604) and with an insertion chamfer (605) which is configured to center the ground contact module (100).

16. Control unit (1000) according to claim 13 or 15, **characterized in that** the potting compound (500) comprises a thermoset, preferably polyurethane.

17. Control unit (1000) according to any of claims 13, 15 or 16, **characterized in that** the potting compound (500) is designed to form a form-fit and material-fit connection to the support part (120).

18. Assembly method for assembling a motor vehicle control unit (1000), wherein the assembly method comprises the steps of:
- connecting a circuit board (300) to an electronics housing (200),
- providing at least one ground contact module (100) according to any of claims 1 to 12
- pressing the press-fit contact (110) of the ground contact module (100) into a corresponding opening of the circuit board (300) to form an electrically conductive connection, and
- pouring a potting compound (500) into the electronics housing (200) to embed the circuit board (300), wherein the support part (120) is embedded at least partially by the potting compound (500) to form a force-conducting connection between the circuit board (300) and the press-fit contact (110).

## Revendications

1. Module de contact de masse (100) pour un appareil de commande (1000) (ECU), comprenant :
- un contact à enfoncer (110) s'étendant dans une direction longitudinale (L), comportant une section d'enfichage (111) pour réaliser une connexion électriquement conductrice par enfoncement à une carte de circuit imprimé (300), et une section formant extrémité (114) espacée dans la direction longitudinale (L) et réalisée pour venir en appui sur une surface d'appui (604),
**caractérisé par**
- une pièce de support (120) reliée au contact à enfoncer (110) et conçue pour former, en réalisant une liaison par complémentarité de forme et/ou une liaison de matière avec une masse de scellement (500), une liaison conductrice de forces entre la carte de circuit imprimé (300) et le contact à enfoncer (110), dans lequel
la pièce de support (120) présente une section de guidage (121) et une section d'ancrage (122) faisant saillie transversalement à la direction longitudinale (L) par rapport à la section de guidage (121),
dans lequel la section de guidage (121) est conçue pour être reliée au contact à enfoncer (110) et la section d'ancrage (122) est conçue pour être reliée par complémentarité de forme à la masse de scellement (500).

2. Module de contact de masse (100) selon la revendication 1,
**caractérisé en ce que** la section d'ancrage (122) présente une plaque d'ancrage (126) et au moins un élément d'application de force (128) disposé entre la plaque d'ancrage (126) et la section formant extrémité (114).

3. Module de contact de masse (100) selon l'une des revendications précédentes, **caractérisé en ce que** la pièce de support (120) est réalisée d'un seul tenant avec un pont de connexion (400).

4. Module de contact de masse (100) selon l'une des revendications précédentes, **caractérisé en ce que** la pièce de support (120) comprend une matière thermoplastique, en particulier du poly(butylène téréphtalate) ou du polyamide.

5. Module de contact de masse (100) selon la revendication 4, **caractérisé en ce que** la matière thermoplastique est une matière thermoplastique renforcée de fibres comportant une teneur en fibres d'au moins 10 %, de préférence de 20 %.

6. Module de contact de masse (100) selon l'une des revendications précédentes, **caractérisé en ce que** la pièce de support (120) est un isolateur électrique.

7. Module de contact de masse (100) selon l'une des revendications précédentes, **caractérisé en ce que** la section formant extrémité (114) présente une première branche (116) et une seconde branche (118) qui s'étendent dans la direction longitudinale (L) et qui sont mobiles l'une par rapport à l'autre ou déformables, de manière élastique, transversalement à la direction longitudinale (L) afin de venir respectivement en appui sur une surface d'appui (604).

8. Module de contact de masse (100) selon la revendication 7,
**caractérisé en ce que** la section de guidage (121) présente une ouverture de guidage (123) s'étendant dans la direction longitudinale (L) et dans laquelle la première branche (116) et la seconde branche (118) sont reçues mobiles transversalement à la direction longitudinale (L).

9. Module de contact de masse (100) selon l'une des revendications précédentes, **caractérisé en ce que** la pièce de support (120) présente une ouverture à enfoncement (124) et le contact à enfoncer (110) est conçu pour être relié à la pièce de support (120) par un enfoncement dans l'ouverture à enfoncement (124) dans une direction d'enfoncement (E).

10. Module de contact de masse (100) selon la revendication 9,
**caractérisé en ce que** le contact à enfoncer (110) présente un certain nombre d'éléments de retenue (119) qui sont conçus de manière à empêcher un déplacement du contact à enfoncer (110) par rapport à la pièce de support (120) dans le sens opposé à la direction d'enfoncement (E).

11. Module de contact de masse (100) selon l'une des revendications précédentes, **caractérisé en ce que** le contact à enfoncer (110) est conçu pour être relié à la pièce de support (120) par un enfoncement au moyen d'un encastrement par ultrasons.

12. Module de contact de masse (100) selon l'une des revendications 1 à 8, **caractérisé en ce que** la pièce de support (120) est fabriquée par un procédé de moulage par injection dans lequel le contact à enfoncer (110) est placé dans l'outil formant moule d'injection et le contact à enfoncer (110) est recouvert par injection pour fabriquer la pièce de support (120) et être relié à la pièce de support (120).

13. Appareil de commande (1000) (ECU) pour un véhicule automobile, comprenant :
- un boîtier pour équipement électronique (200),
- une carte de circuit imprimé (300) disposée dans le boîtier pour équipement électronique (200),
- une masse de scellement (500) dans laquelle est encastrée la carte de circuit imprimé (300),
- une surface d'appui (604) métallique, et
- au moins un module de contact de masse (100) permettant de connecter de manière électriquement conductrice la carte de circuit imprimé (300) à la surface de d'appui (604) métallique, **caractérisé en ce que** le module de contact de masse (100) comprend :
- un contact à enfoncer (110) s'étendant dans une direction longitudinale (L), comportant une section d'enfichage (111) pour réaliser une connexion électriquement conductrice par enfoncement à la carte de circuit imprimé (300), et une section formant extrémité (114) espacée dans la direction longitudinale (L) et réalisée pour venir en appui sur la surface d'appui (604), et
- une pièce de support (120) reliée au contact à enfoncer (110) et formant, en réalisant une liaison par complémentarité de forme et/ou une liaison de matière avec la masse de scellement (500), une liaison conductrice de forces entre la carte de circuit imprimé (300) et le contact à enfoncer (110).

14. Appareil de commande (1000) selon la revendication 13,
**caractérisé en ce que** le module de contact de masse (100) est réalisé selon l'une des revendications 1 à 12.

15. Appareil de commande (1000) selon la revendication 13, **caractérisé par** un alésage (602) d'une paroi qui réalise la surface d'appui (604), et un chanfrein d'insertion (605) conçu pour centrer le module de contact de masse (100).

16. Appareil de commande (1000) selon la revendication 13 ou 15, **caractérisé en ce que** la masse de scellement (500) comprend une résine thermodurcissable, de préférence du polyuréthane.

17. Appareil de commande (1000) selon l'une des revendications 13, 15 ou 16, **caractérisé en ce que** la masse de scellement (500) est réalisée pour être reliée, par complémentarité de forme et par liaison de matière, à la pièce de support (120).

18. Procédé de montage permettant le montage d'un appareil de commande (1000) pour un véhicule automobile, dans lequel le procédé de montage comprend les étapes consistant à :
- connecter une carte de circuit imprimé (300) à un boîtier pour équipement électronique (200),
- fournir au moins un module de contact de masse (100) selon l'une des revendications 1 à 12,
- enfoncer le contact à enfoncer (110) du module de contact de masse (100) dans une ouverture correspondante de la carte de circuit imprimé (300) pour la formation d'une connexion électriquement conductrice, et
- mouler une masse de scellement (500) dans le boîtier pour équipement électronique (200) pour l'incorporation de la carte de circuit imprimé (300), dans lequel la pièce de support (120) est incorporée, au moins dans certaines sections, dans la masse de scellement (500) pour la réalisation d'une liaison conductrice de forces entre la carte de circuit imprimé (300) et le contact à enfoncer (110).
